# EUROPEAN PATENT SPECIFICATION

(11) **EP 3 570 339 B1**
(45) Date of publication and mention of the grant of the patent: **30.12.2020**
(21) Application number: 18173009.4
(22) Date of filing: 17.05.2018
(51) Int. Cl.: H01L 45/00

(54) **SWITCHING DEVICE WITH ACTIVE PORTION SWITCHING FROM INSULATING STATE TO CONDUCTING STATE**
SCHALTVORRICHTUNG MIT AKTIVER TEILUMSCHALTUNG VOM ISOLIERUNGSZUSTAND ZUM LEITENDEN ZUSTAND
DISPOSITIF DE COMMUTATION AVEC COMMUTATION DE PARTIE ACTIVE DE L'ÉTAT ISOLANT À L'ÉTAT CONDUCTEUR

(43) Date of publication of application: 20.11.2019
(73) Proprietor: IMEC vzw, 3001 Leuven (BE)
(72) Inventor: GARBIN, Daniele, 3001 LEUVEN (BE); DEGRAEVE, Robin, 3001 LEUVEN (BE); GOUX, Ludovic, 3001 LEUVEN (BE)
(74) Representative: Plasseraud IP

(56) References cited:
- US-A1- 2008 006 811
- US-A1- 2008 017 841

## Description

The invention relates to a switching device which is based on an active portion capable of switching from an insulating state to a conductive state.

### -- BACKGROUND OF THE INVENTION --

Electronic devices capable of controlled switching are useful for many applications, including selection arrays for random access memories. Then, implementation issues for such switching devices are low switching voltage threshold, low leakage current, short response time and high reliability. Other issues related to circuit manufacturing are simple design of the switching device, compatibility with high level for circuit integration and low manufacturing cost.

For addressing some of these issues, document US 6,967,344 proposes multi-terminal electronic switching devices which are based each on a portion of a chalcogenide material. The most common chalcogen elements are sulphur, selenium and tellurium, which may be combined with many metal elements for forming materials that are capable of switching between an electrically insulating state and an electrically conducting state. Some of these materials are ovonic materials, and have been described in particular in the article entitled "Analytical model for subthreshold conduction and threshold switching in chalcogenide-based memory devices", by D. lelmini et al., Journal of Applied Physics 102, 054517 (2007). For example, one such ovonic material is Ge₂Sb₂Te₅. When initially in the insulating state, an ovonic material portion switches to the conducting state when a voltage which is applied to the portion becomes higher than a threshold. Usual values for the ovonic threshold voltage are comprised between 1.2 V (volt) and 2.2 V for portion thicknesses ranging between 8 nm (nanometer) and 32 nm. But such threshold voltage values are high with respect to the voltage values that are commonly available in integrated circuits, and special control design is therefore necessary for triggering the switching of such ovonic material portion. In particular, document US 6,967,344 implements a switching device design which comprises top and bottom electrodes arranged on opposed sides of an ovonic material portion, but also an additional control electrode which is useful for producing within the portion a voltage distribution which is suitable for causing transition from insulating to conducting state. However, such three-electrode design for the switching device requires a complicated manufacturing process and an in-use complicated control mode. Further examples of prior art may be found in patent documents US2008/0017841 and US2008/0006811.

Then, one object of the present invention consists in providing new electronic switching devices which are simple for manufacturing and can be operated with simple control mode.

Another object of the invention consists in providing such electronic switching devices which are compatible with manufacturing processes that exist to-date for integrated electronic circuits, and compatible with voltage values that are commonly available to-date within integrated circuits.

### -- SUMMARY OF THE INVENTION --

For meeting at least one of these objects or others, a first aspect of the present invention proposes a switching device which comprises:
- at least two electrodes which are arranged apart from each other;
- an active portion which is intermediate between both electrodes and in electrical contact with each electrode, the active portion being selected so that it is capable of switching from an electrically insulating state to an electrically conducting state when a voltage which is higher than a threshold value is applied between both electrodes, wherein an electrical resistance of the active portion existing between both electrodes is lower for the conducting state compared to the insulating state; and
- a passive portion which is electrically insulating and arranged adjacent to the active portion.

According to the invention, a material composition of at least one among the active portion and the passive portion varies between two points of at least one path from one of the electrodes to the other electrode. Such variation in the material composition is selected so that a relative dielectric permittivity is non-uniform along the path, and creates an electrical field concentration at at least one location within the active portion when in the insulating state and a non-zero voltage is applied between both electrodes. Put another way, the electrical field is higher at the concentration location than at another location also within the active portion.

Because the variation in the dielectric permittivity concentrates the electrical field at one location within the active portion, the voltage threshold which is effective for causing the active portion to switch from insulating state to conducting state is not too high. Thus, switching of the active portion can be obtained through simple two-electrode control mode, without a third control electrode being necessary. To promote the electrical field concentration effect, the variation of the relative dielectric permittivity between two points of the path is higher than 6, and preferably higher than 10, most preferably higher than 20.

Thanks to the two-electrode control mode, the design of the invention switching device can be simple, and is compatible with low-cost manufacturing processes.

In addition, the design of the invention switching device provides a trade-off between limited voltage to be applied between the electrodes but sufficient for producing the switching operation, and low leakage current through the active portion when in the insulating state.

In preferred embodiments of the invention, the material of the active portion may be an ovonic material. In particular, using an ovonic material for the active portion allows obtaining low leakage current in the insulating state, short response time and high reliability for the switching device.

Generally for the invention, for both electrodes, a respective contact interface between the active portion and one of the electrodes may be perpendicular to a rectilinear direction which extends from one of the electrodes to the other one. For such configuration, the active portion may have side faces which are parallel to the rectilinear direction. This corresponds to the active portion having a pillar shape which extends from one of the electrodes to the other one, with the interfaces between the active portion and the electrodes which are perpendicular to the pillar direction. Then, the passive portion may be located between two planes which contain the contact interfaces and are perpendicular to the rectilinear direction of the pillar, and the passive portion may surround at least partially the active portion laterally.

In first possible embodiments of the invention, the material composition of the active portion varies between both electrodes so that the relative dielectric permittivity is non-uniform within the active portion. In such cases, the above-mentioned path extends through the active portion. Then, respective cross-sections of the active portion and of the electrodes may be identical, each cross-section being perpendicular to the rectilinear direction.

In second possible embodiments of the invention, each electrode may extend perpendicular to the rectilinear direction beyond at least one side face of the active portion. Then, the material composition of the passive portion may vary between respective protrusions of the electrodes that extend laterally beyond the side face of the active portion, so that the relative dielectric permittivity is non-uniform within the passive portion between the electrode protrusions. In such other cases, the above-mentioned path extends through the passive portion. In particular, the passive portion may then be a stack of at least two electrically insulating layers, and the active portion is then arranged through the stack.

In preferred ones of the second embodiments of the invention, a first one of the layers of the passive portion has a value ε_{LK} for the relative dielectric permittivity and a thickness t_{LK}, and a second one of the layers of the passive portion has a value ε_{HK} for the relative dielectric permittivity and a thickness t_{HK}, and the following inequalities are met: ε_{LK} < ε_{HK} and t_{LK} < t_{HK}, the thicknesses being measured parallel to the rectilinear direction.

Generally when the active portion has a pillar shape, the switching device may further comprise a metal portion which is arranged adjacent to the active portion, this metal portion having a thickness which is less than a separating distance existing between both electrodes. To this purpose, the thickness of the metal portion and the separating distance are measured parallel to the rectilinear direction. In this way, the metal portion promotes the localized concentration of the electrical field within the active portion in a further extent. The metal portion preferably surrounds the active portion laterally. It may also be electrically insulated from each of the electrodes, for example as a floating metal portion or a metal portion which is biased separately from both electrodes of the switching device.

In addition, for some of the second embodiments of the invention as recited above, the metal portion may be located between respective portions of both electrically insulating layers of the passive portion.

A second aspect of the invention further proposes a selection array which comprises:
- a layer of first electrodes, all first electrodes being formed by respective first conducting tracks that are spaced from each other and parallel to a first direction;
- a layer of second electrodes, all second electrodes being formed by respective second conducting tracks that are spaced from each other and parallel to a second direction, the layers of the first and second electrodes being both parallel to a base plane and the first and second directions crossing each other in projection on the base plane;
- active portions which are arranged between the layer of the first electrodes and the layer of the second electrodes, so that each active portion bridges one of the first electrodes and one of the second electrodes with respective electrical contact interfaces; and
- passive material which is located between neighboring ones of the active portions.

In such selection array, each active portion forms a switching device according to the first invention aspect, with respective portions of one of the first electrodes and one of the second electrodes, and at least one portion of the passive material which is adjacent to the active portion. In particular, the array may form a random access memory selection array.

Finally, a third aspect of the invention further proposes a method of manufacturing at least one switching device, which comprises one of the first and second step sequences recited below.

The first step sequence comprises:
/1/ obtaining a base structure having a planar surface and comprising at least one first electrode which is flush with the planar surface;
/2/ forming a layer of an active material on the planar surface of the base structure, the active material being selected for being capable of switching from an electrically insulating state to an electrically conducting state when a voltage which is higher than a threshold value is applied between two opposed surfaces of this layer of active material;
/3/ removing the layer of the active material selectively outside an area which is located above the first electrode, so that a portion of the active material, called active portion, remains on said first electrode;
/4/ deposition of a dielectric material on the base structure, so that the active portion is embedded within the dielectric material;
/5/ polishing the dielectric material so that the active portion is flush with a planar abrasion surface of the dielectric material on a side opposed to the base structure; and
/6/ forming the second electrode on the active portion on the side opposed to the base structure.

The second step sequence comprises:
/1'/obtaining a base structure having a planar surface and comprising at least one first electrode which is flush with the planar surface;
/2'/ deposition of a dielectric material layer on the planar surface of the base structure;
/3'/ removing the dielectric material selectively inside an area which is comprised in a cross-section of the first electrode parallel to the planar surface of the base structure, so as to form a cavity which extends to the first electrode;
/4'/ filling the cavity with an active material selected for being capable of switching from an electrically insulating state to an electrically conducting state when a voltage which is higher than a threshold value is applied between two opposed surfaces of a portion of the active material;
/5'/ polishing the active material so that the dielectric material layer is flush with a planar abrasion surface on a side opposed to the base structure, the cavity filled with the active material forming an active portion; and
/6'/ forming the second electrode on the active portion on the side opposed to the base structure.

When the method is to produce at least one switching device in accordance with one of the first embodiments that have been mentioned for the first invention aspect, the active material is varied in composition during step /2/ or /4'/, so that a relative dielectric permittivity of this active material is non-uniform along a direction perpendicular to the planar surface of the base structure.

Alternatively, when the method is to produce at least one switching device in accordance with one of the second embodiments, the dielectric material is varied in composition during step /4/ or /2'/, so that a relative dielectric permittivity of this dielectric material is non-uniform along the direction perpendicular to the planar surface of the base structure.

Possibly, both implementations may be combined, so that the active material and the dielectric material both vary in composition along the direction perpendicular to the planar surface of the base structure. In this way, an increased concentration of the electrical field may be obtained within the active portion.

These and other features of the invention will be now described with reference to the appended figures, which relate to preferred but not-limiting embodiments of the invention.

### -- BRIEF DESCRIPTION OF THE DRAWINGS --

Figure 1 is a cross-sectional view of a switching device according to a first embodiment of the invention.
Figures 2a and 2b are cross-sectional views of two switching devices according to second embodiments of the invention.
Figures 3a is a perspective view a selection array comprised of switching devices which are in accordance with the first embodiment of figure 1.
Figure 3b corresponds to figure 3a for the second embodiment of figure 2a.
Figure 4a-4f are cross-sectional views which illustrate steps of a first method suitable for manufacturing switching devices according to the invention.
Figures 5a-5f correspond to figures 4a-4f for a second manufacturing method.

For clarity sake, element sizes which appear in these figures do not correspond to actual dimensions or dimension ratios. Also, same reference numbers which are indicated in different ones of these figures denote identical elements of elements with identical function.

### -- DETAILED DESCRIPTION OF THE INVENTION --

In the figures, reference number 10 generally denotes a switching device as provided by the invention. For illustration purpose but not limitedly, the switching devices described comprise each an active portion 3 of an ovonic material. Such ovonic material is capable of switching from an electrically insulating state to an electrically conducting state when a voltage which is applied to the active portion 3 reaches a threshold. Thus, the switching devices 10 are of the type commonly called ovonic threshold switch. For example, at least part of the active portion 3 may have one of the material compositions Ge₂Sb₂Te₅ and GeSₓ.

Each switching device 10 comprises a first electrode 1, the active portion 3 and a second electrode 2 which are superposed along a rectilinear direction D. P₁ denotes a plane which is superposed to an interface I₁ existing between the electrode 1 and the active portion 3, and P₂ denotes another plane which is superposed to an interface I₂ existing between the electrode 2 and the active portion 3. In preferred designs for the switching devices 10, the planes P₁ and P₂ are parallel and spaced by a distance equal to a thickness of the active portion 3. The electrodes 1 and 2 may be comprised of copper, or a copper-based alloy. Possibly, a suitable electrically conducting interface layer (not represented) may be arranged between the active portion 3 and each one of the electrodes 1 and 2.

Each switching device 10 further comprises a dielectric material portion 4 which is adjacent to the active portion 3 at at least one side face SF of this latter. Such dielectric material portion 4 has been called passive portion in the general part of the description. Preferably, the passive portion 4 surrounds laterally the active portion 3 between both planes P₁ and P₂.

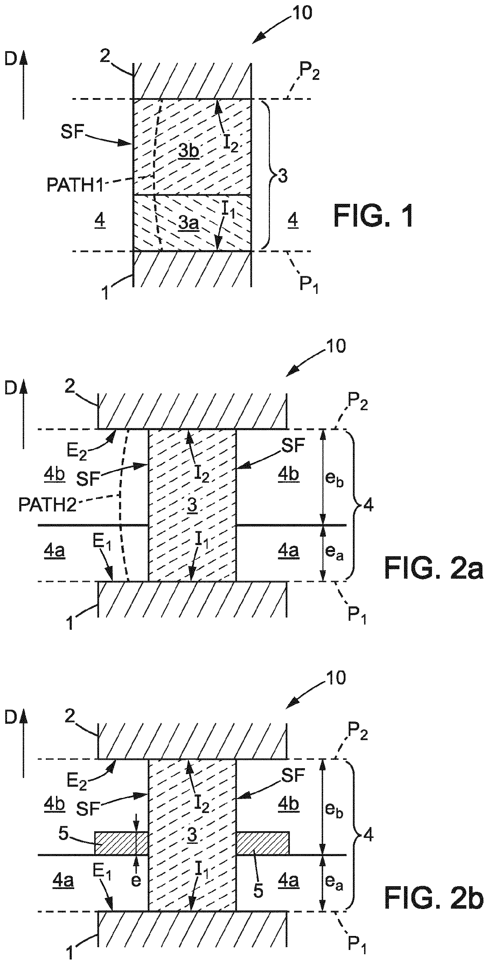

In the embodiment represented in figure 1, respective cross-sections of the active portion 3 and of the electrodes 1 and 2 may be identical, perpendicular to the direction D. Put another way, each of the electrodes 1 and 2 has respective lateral edges which are aligned with the side faces SF of the active portion 3. The active portion 3 has a material composition which varies along the direction D. For example, a lower part 3a of the active portion 3 may have the ovonic composition Ge₂Sb₂Te₅, with relative dielectric permittivity value of about 12, whereas an upper part 3b of the active portion 3 may have a different ovonic composition, for example GeSₓ with relative dielectric permittivity value of about 20. Such difference in the dielectric permittivity value between both parts 3a and 3b, together with a boundary between both parts 3a and 3b which is perpendicular to the direction D, causes that a voltage which is applied between both electrodes 1 and 2 has a steeper gradient in that one of the parts 3a and 3b which has the lowest permittivity value. So, the electrical field is higher within this part of the active portion 3 with the lowest permittivity value, when compared to the electrical field in the other part of the active portion 3. In accordance with the general part of this description, the electrical field is said to be concentrated at a location within the part 3a of the active portion 3. Since the transition from insulating state to conducting state of the ovonic material is triggered by the electrical field reaching a critical field value, the distribution of the active portion 3 into two parts having dielectric permittivity values which are different allows reaching the critical field value at first within the part 3a, for a voltage value applied between both electrodes 1 and 2 which is lower when compared to the material of part 3a constituting the whole active portion 3 with identical total thickness. A further optimized design of the switching device 10 is obtained when the ovonic material of the part 3a has not only a dielectric permittivity value which is lower than that of the ovonic material of the part 3b, but also has a critical field value which is lower than the critical field value of the ovonic material of the part 3b. Once the part 3a of ovonic material has switched to conducting state, it triggers immediately the part 3b to switch in turn to conducting state, because the electrical field has then become concentrated within the part 3b only. For example, the part 3a of the active portion 3 may be 20 nm in thickness along the direction D, and the part 3b may be 25 nm-thick.

For connection with the general part of the invention description, PATH1 extends through the active portion parts 3a and 3b from the electrode 1 to the electrode 2. The variation in the ovonic material at the boundary between both parts 3a and 3b produces the variation in the dielectric permittivity value at one location on PATH1.

In the embodiment represented in figure 2a, the electrodes 1 and 2 have dimensions perpendicular to the direction D which are greater than those of the active portion 3. Then, E₁ denotes a lateral protrusion of the electrode 1, which extends beyond the side face SF of the active portion 3. E₂ has the same meaning for the electrode 2. Preferably, such lateral protrusions of the electrodes 1 and 2 are identical and may exist all around the active portion 3. In addition, the active portion 3 may have a uniform material composition, for example GeSₓ. Then, the passive portion 4 extends to the side faces SF of the active portion 3 between the electrode protrusions E₁ and E₂. In such embodiment, the passive portion 4 is comprised of at least two layers 3a and 3b which are superposed along the direction D, and which have respective dielectric permittivity values that are different. For example, the layer 3a may be a silica (SiO₂) layer, with relative dielectric permittivity value ε_{LK} equal to about 3.9, and the layer 3b may be a hafnium oxide (HfO₂) layer, with relative dielectric permittivity value ε_{HK} equal to about 25. Such variation in the dielectric permittivity value within the passive portion 4 causes the electrical field to be higher in that one of the layers 4a and 4b which has the lowest permittivity value, between the electrode protrusions E₁ and E₂, when compared to the electrical field in the other layer. Then, the electrical field in the active portion 3 is concentrated at a location within this active portion which is close to the layer of the passive portion 4 which has the lowest dielectric permittivity value. This is due to continuity of the component of the electrical field which is parallel to the side face SF, between the passive portion 4 and the active portion 3. Thus, a concentration effect for the electrical field also exists for such second embodiment, although the material of the active portion 3 is uniform. For increasing such concentration effect, the thickness along the direction D of that one of the layers 4a and 4b which has the lowest dielectric permittivity value is preferably smaller than the thickness of the other layer. For example, the SiO₂-layer 3a may be 10 nm in thickness, and the HfO₂-layer 3b may be 20 nm in thickness. The thickness eₐ of the layer 4a indicated in figure 2a corresponds to e_{LK} as mentioned in the general part of the description, and the thickness e_{b} of the layer 4b corresponds to e_{HK}.

For connection with the general part of the invention description, PATH2 extends through the layers 4a and 4b from the lateral protrusion E₁ of the electrode 1 to the lateral protrusion E₂ of the electrode 2. The variation in the dielectric material at the boundary between both layers 4a and 4b produces the variation in the dielectric permittivity value at one location on PATH2.

The embodiment of figure 2b corresponds to that of figure 2a, except that a metal portion 5 has been added adjacent to the boundary between the layers 4a and 4b, and also adjacent to the active portion 3. The metal portion 5 may have a thickness e of about 5 nm, when measured parallel to the direction D. Preferably, it surrounds the active portion 3 laterally as a ring, by forming a complete loop perpendicular to the direction D. Because the electrical field is low or almost zero within the metal portion 3, and the component of the electrical field which is parallel to the side face SF is continuous between the metal portion 5 and the active portion 3, the metal portion 5 causes the electrical field to be more concentrated at one location within the active portion 3. This lowers in a further extent the voltage value to be applied between both electrodes 1 and 2 for producing the critical field value of the ovonic material at the electrical field concentration location within the active portion 3. The metal portion 5 may be either a floating metal portion, i.e. electrically isolated from any electrode of a circuit which comprises the switching device 10, or a biased metal portion, i.e. connected electrically to an electrode of the circuit, including possibly connected to one of the electrodes 1 and 2 of the switching device 10.

The improvement of the invention which consists in adding the metal portion 5 may also be combined with the embodiment of figure 1, in a way similar to that described with reference to figure 2b.

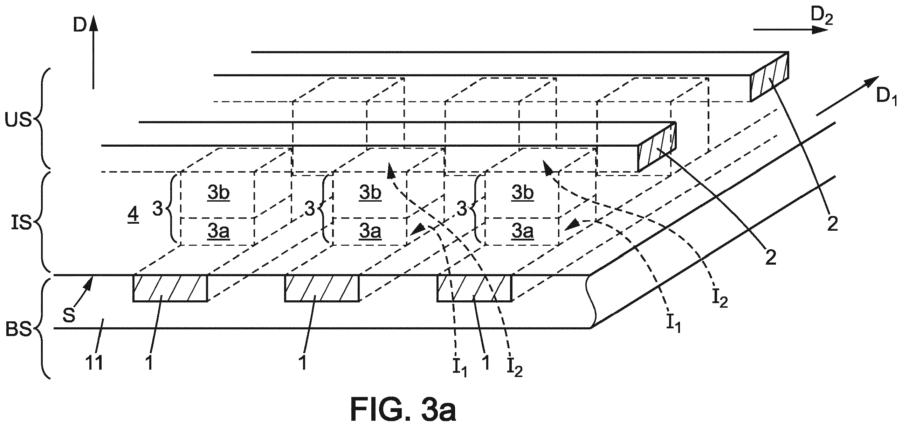

Figure 3a illustrates a selection array which is based on the invention embodiment of figure 1. Such selection array has a cross-point configuration, and is suitable for forming a random access memory selection array. Combination of such cross-point selection array with a matrix of random access memory elements is well known, so that it is not described here.

As represented in figure 3a, a plurality of line electrodes 1 are arranged parallel to a common direction D₁ at a planar surface S of an insulating substrate 11. The planar surface S has been called base plane in the general part of this description. The line electrodes 1 are preferably regularly spaced, and separated from each other by intermediate regions of the substrate 11. The substrate 11 and the line electrodes 1 form a base structure BS of the selection array. An intermediate structure IS which comprises the active portions 3 surrounded by dielectric material is arranged on top of the base structure BS. The active portions 3 extend from the planar surface S to the opposed surface of the intermediate structure IS. For each active portion 3, a respective part of the dielectric material which is adjacent to this active portion 3 forms the corresponding passive portion 4 as mentioned above in this description. Finally, an upper structure US is arranged on top of the intermediate structure IS, which comprises a plurality line electrodes 2. The line electrodes 2 are parallel to a common direction D₂, preferably regularly spaced and separated from each other by intermediate insulating regions of the upper structure US. The line electrodes 2 may also be oriented perpendicular to the line electrodes 1, as this appears in projection on the planar surface S. The line electrodes 2 are in electrical contact with the active portions 3, so that each active portion 3 connects electrically one of the line electrodes 1 with one of the line electrodes 2, according to a matrix arrangement which provides a respective connection between any one of the line electrodes 1 and any one of the line electrodes 2.

According to the invention, the active portions 3 are each comprised of at least two parts 3a and 3b, which are superposed along the direction D and different in dielectric permittivity value.

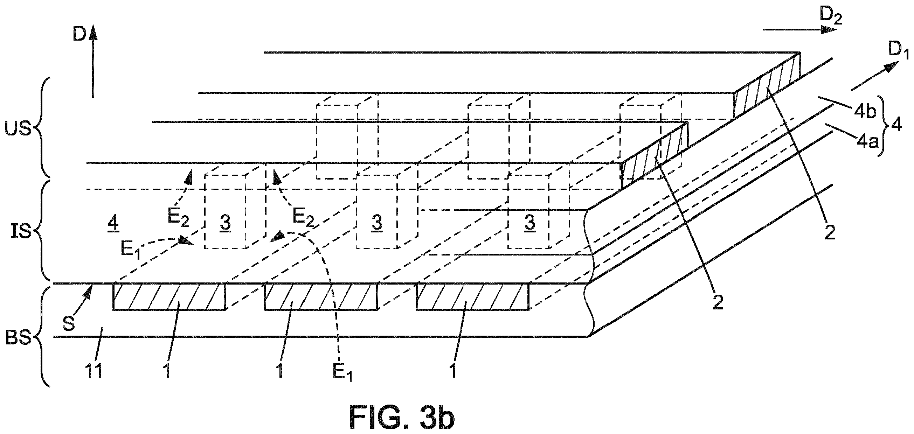

Obviously, other selection arrays may be designed similarly but based on the invention embodiments of figures 2a or 2b. In such other selection arrays, the line electrodes 1 and 2 are each larger in width that the active portions 3. In this way, lateral rim portions of the line electrodes 1 and 2 and the continuous extension of these line electrodes between the active portions 3 form the lateral protrusions E₁ and E₂ as represented in figures 2a at 2b. Figure 3b shows such a selection array in which the switching devices correspond individually to figure 2a.

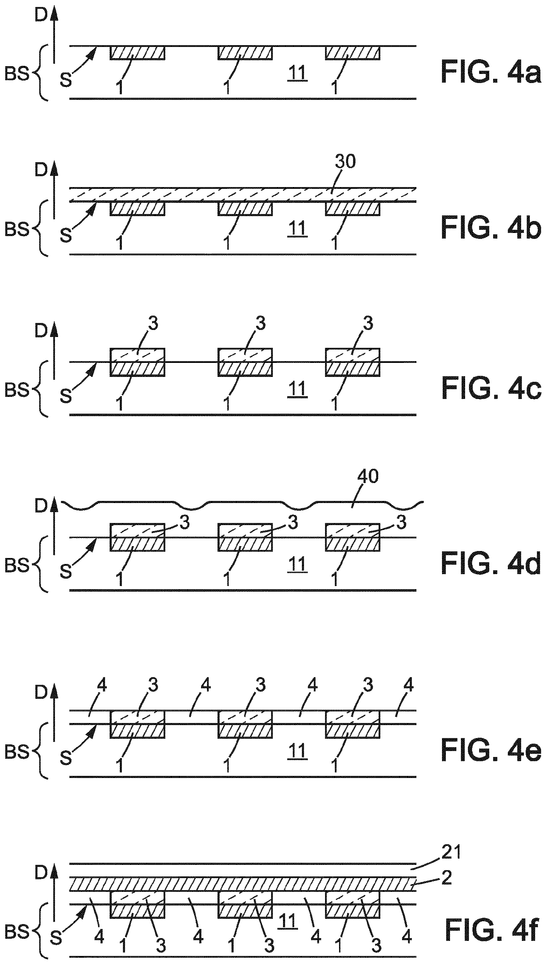

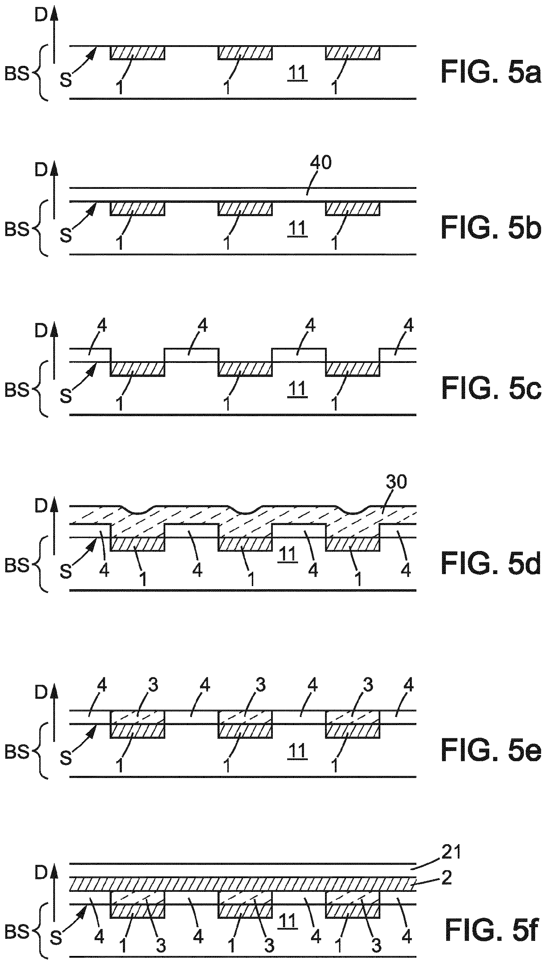

Two manufacturing step sequences are now described with reference to figures 4a-4f and 5a-5f, respectively, which are each suitable for producing selection arrays as shown in figures 3a and 3b. These manufacturing sequences implement Damascene processes, including masking, material deposition and polishing steps which are supposed to be well-known, so that only the step sequences are recited below without describing each step in detail.

Figures 4a and 5a, which are identical, show the base structure BS which constitutes the initial configuration of a selection array being manufactured. In this the base structure BS, the line electrodes 1 are uncovered. They may be copper-based and the insulating material 11 may be silica supported by any substrate (not shown).

According to figure 4b, an active material layer 30, actually an ovonic material layer in the embodiments considered, is deposited on the planar surface S of the base structure BS. If the selection array is to be comprised of switching devices 10 which have each a configuration as shown in figure 1, the layer 30 is comprised of a first sublayer which is deposited at first, for example a layer of the ovonic material Ge₂Sb₂Te₅, followed by a second sublayer, for example a layer of the ovonic material GeSeₓ. The second sublayer is deposited preferably shortly or immediately after the first one and on top of it for avoiding that pollutes be present at the interface between both sublayers of ovonic materials. Alternatively, if the selection array is to be comprised of switching devices 10 which have each a configuration as shown in figure 2a, the layer 30 is uniform, for example comprised of GeSeₓ only.

Then, the layer 30 is etched (figure 4c) selectively so that portions thereof only remain above selected areas of the line electrodes 1. These remaining portions of the layer 30 form the active portions 3 of the selection array.

A layer of dielectric material 40 (figure 4d) is then deposited above the base structure BS and the active portions 3, so as to completely fill spaces existing between neighbouring ones of the active portions 3. To this end, a thickness of the layer of dielectric material 40 along the direction D is greater than that of the active portions 3. If the selection array is to be comprised of switching devices 10 which have each a configuration as shown in figure 1, the layer of dielectric material 40 is uniform, for example comprised of silica only. Alternatively, if the selection array is to be comprised of switching devices 10 which have each a configuration as shown in figure 2a, the layer of dielectric material 40 is comprised of a first sublayer which is deposited at first, for example a layer of silica, followed by a second sublayer, for example a layer of hafnium oxide.

The layer of dielectric material 40 is then polished so as to recover a planar upper surface and expose the active portions 3 (figure 4e). The layer of dielectric material 40 thus constitutes the passive portions 4 which surround the active portions 3. At this stage, the base structure BS is provided with the intermediate structure IS.

Finally, the selection array is completed by forming the upper structure US. A first part of a layer of insulating material 21 is deposited on top of the intermediate structure IS, and etched selectively at the locations of the line electrodes 2. A conducting material, for example copper, may be deposited into the cavities etched for forming the line electrodes 2. Then, the layer of insulating material 21 may be completed so that the line electrodes 2 are embedded within the upper structure US.

The step sequence of figures 5a-5f differs from that of figures 4a-4f in that the dielectric material 40 is deposited before the ovonic material.

According to figure 5b, a dielectric material layer 40 is deposited on the planar surface S of the base structure BS. If the selection array is to be comprised of switching devices 10 which have each a configuration as shown in figure 1, this layer is uniform in composition, such as a silica layer. Alternatively, for switching devices 10 as shown in figure 2a, the layer of dielectric material 40 is comprised of a first sublayer which is deposited at first, for example a layer of silica, followed by a second sublayer, for example a layer of hafnium oxide.

Then, the layer of dielectric material 40 is etched (figure 5c) selectively at locations where the active portions 3 are to be formed. These locations are situated above parts of the line electrodes 1, and the selective etching of the layer of dielectric material 40 is continued until the line electrodes 1 become uncovered at the bottom of the etching cavities. The remaining part of the layer of dielectric material 40 forms the passive portions 4 of the selection array.

A layer of active material 30 (figure 5d) is then deposited above the base structure BS and the passive portions 4, so as to completely fill the cavities previously etched in the dielectric material layer 40. To this end, a thickness of the layer of active material 30 along the direction D is higher than that of the passive portions 4. If the selection array is to be comprised of switching devices 10 which have each a configuration as shown in figure 1, the layer of active material 30 is comprised of a first sublayer which is deposited at first, for example a layer of the ovonic material Ge₂Sb₂Te₅, followed by a second sublayer, for example a layer of the ovonic material GeSeₓ. Alternatively, if the selection array is to be comprised of switching devices 10 which have each a configuration as shown in figure 2a, the layer 30 is uniform, for example comprised of GeSeₓ only.

The layer of active material 30 is then polished so as to recover a planar upper surface and expose the passive portions 4 (figure 5e). After completion of the polishing step, the active portions 3 remain and are separated by the surrounding passive portions 4, thus forming the intermediate structure IS.

The upper structure US is then formed (figure 5f), possibly as described with reference to figure 4f.

Although it does not appear in figures 4a-4f and 5a-5f, when switching devices 10 according to the embodiment of figure 2a are to be manufactured, the lateral dimensions of the active portions 3 and the width of each line electrode 1 or 2 are to be modified so that each active portion is smaller in width than each line electrode.

The Man skilled in the art will be capable of adapting these step sequences for manufacturing a selection array in which the switching devices 10 are in accordance with figure 2b, i.e. with metal portions 5.

Other adaptations may be introduced while maintaining at least some of the invention advantages which have been mentioned. In particular, the materials cited were only for exemplifying purpose and may be replaced by others.

## Claims

1. A switching device (10) comprising:
- at least two electrodes (1, 2) which are arranged apart from each other;
- an active portion (3) which is intermediate between both electrodes (1, 2) and in electrical contact with each electrode, the active portion being selected so that said active portion is capable of switching from an electrically insulating state to an electrically conducting state when a voltage which is higher than a threshold value is applied between both electrodes, wherein an electrical resistance of the active portion existing between both electrodes is lower for the conducting state compared to the insulating state; and
- a passive portion (4) which is electrically insulating and arranged adjacent to the active portion,
wherein a material composition of at least one among the active portion (3) and the passive portion (4) varies between two points of at least one path (PATH1; PATH2) from one of the electrodes (1) to the other electrode (2), so that a relative dielectric permittivity is non-uniform along said path, thereby creating a concentration of electrical field at at least one concentration location within the active portion (3) when in the insulating state and a non-zero voltage is applied between both electrodes (1, 2), the electrical field being thus higher at the concentration location than at another location also within said active portion,
**characterized in that** a variation of the relative dielectric permittivity between two points of the path (PATH1; PATH2) is higher than 6.

2. The switching device (10) of claim 1, wherein the variation of the relative dielectric permittivity between two points of the path (PATH1; PATH2) is higher than 10, more preferably higher than 20.

3. The switching device (10) of claim 1 or 2, wherein for both electrodes (1, 2), a respective contact interface (I₁, I₂) between the active portion (3) and one of the electrodes is perpendicular to a rectilinear direction (D) which extends from one of the electrodes to the other electrode, and the active portion (3) has side faces (SF) which are parallel to said rectilinear direction.

4. The switching device (10) of claim 3, wherein the passive portion (4) is located between two planes (P₁, P₂) which contain the contact interfaces (I₁, I₂) and are perpendicular to the rectilinear direction (D), and the passive portion (4) surrounds at least partially the active portion (3) laterally.

5. The switching device (10) of claim 3 or 4, wherein the material composition of the active portion (3) varies between both electrodes (1, 2) so that the relative dielectric permittivity is non-uniform within said active portion, and respective cross-sections of the active portion (3) and of the electrodes (1, 2) are identical, said cross-sections being perpendicular to the rectilinear direction (D).

6. The switching device (10) of any one of claims 3 to 5, wherein each electrode (1, 2) extends perpendicular to the rectilinear direction (D) beyond at least one side face (SF) of the active portion (3), and the material composition of the passive portion (4) varies between respective protrusions (E₁, E₂) of the electrodes (1, 2) that extend laterally beyond the side face (SF) of the active portion (3), so that the relative dielectric permittivity is non-uniform within said passive portion between the electrode protrusions.

7. The switching device (10) of claim 6, wherein the passive portion (4) is a stack of at least two electrically insulating layers (4a, 4b) and the active portion (3) is arranged through the stack.

8. The switching device (10) of claim 7, wherein a first one (4a) of the layers has a value ε_{LK} for the relative dielectric permittivity and a thickness t_{LK}, and a second one (4b) of the layers has a value ε_{HK} for the relative dielectric permittivity and a thickness t_{HK}, and the following inequalities are met: ε_{LK} < ε_{HK} and t_{LK} < t_{HK}, the thicknesses being measured parallel to the rectilinear direction (D).

9. The switching device (10) of any one of claims 3 to 8, further comprising a metal portion (5) which is arranged adjacent to the active portion (3), said metal portion having a thickness which is less than a separating distance existing between both electrodes (1, 2), said thickness of the metal portion and said separating distance being measured parallel to the rectilinear direction (D).

10. The switching device (10) of claim 9, wherein the metal portion (5) surrounds laterally the active portion (3).

11. The switching device (10) of claim 9 or 10, wherein the metal portion (5) is electrically insulated from each of the electrodes (1, 2), preferably the metal portion is a floating metal portion.

12. The switching device (10) of claim 7 and any one of claims 8 to 11, wherein the metal portion (5) is located between respective portions of both electrically insulating layers (4a, 4b) of the passive portion (4).

13. Selection array, comprising:
- a layer of first electrodes (1), all first electrodes being formed by respective first conducting tracks that are spaced from each other and parallel to a first direction (D₁);
- a layer of second electrodes (2), all second electrodes being formed by respective second conducting tracks that are spaced from each other and parallel to a second direction (D₂), the layers of the first and second electrodes being both parallel to a base plane (S) and the first and second directions crossing each other in projection on the base plane;
- active portions (3) which are arranged between the layer of the first electrodes (1) and the layer of the second electrodes (2), so that each active portion bridges one of the first electrodes and one of the second electrodes with respective electrical contact interfaces (I₁, I₂); and
- passive material (4) which is located between neighboring ones of the active portions (3),
so that each active portion (3) forms a switching device (10) according to any one of the preceding claims, with respective portions of one of the first electrodes (1) and one of the second electrodes (2), and at least one portion of the passive material (4) which is adjacent to said active portion.

14. Selection array according to claim 13, suitable for forming a random access memory selection array.

15. Method of manufacturing at least one switching device (10), comprising one of the following first and second step sequences:
the first step sequence comprising:
/1/ obtaining a base structure (BS) having a planar surface (S) and comprising at least one first electrode (1) which is flush with said planar surface;
/2/ forming a layer of an active material (30) on the planar surface (S) of the base structure (BS), the active material being selected for being capable of switching from an electrically insulating state to an electrically conducting state when a voltage which is higher than a threshold value is applied between two opposed surfaces of said layer of active material;
/3/ removing the layer of the active material (30) selectively outside an area which is located above the first electrode (1), so that a portion of the active material, called active portion (3), remains on said first electrode;
/4/ deposition of a dielectric material (40) on the base structure (BS), so that the active portion (3) is embedded within the dielectric material;
/5/ polishing the dielectric material (40) so that the active portion (3) is flush with a planar abrasion surface of the dielectric material on a side opposed to the base structure (BS); and
/6/ forming the second electrode (2) on the active portion (3) on the side opposed to the base structure (BS),
and the second step sequence comprising:
/1'/ obtaining a base structure (BS) having a planar surface (S) and comprising at least one first electrode (1) which is flush with said planar surface;
/2'/ deposition of a layer of dielectric material (40) on the planar surface (S) of the base structure (BS);
/3'/ removing the dielectric material (40) selectively inside an area which is comprised in a cross-section of the first electrode (1) parallel to the planar surface (S) of the base structure (BS), so as to form a cavity which extends to the first electrode;
/4'/ filling the cavity with an active material (30) selected for being capable of switching from an electrically insulating state to an electrically conducting state when a voltage which is higher than a threshold value is applied between two opposed surfaces of a portion of said active material;
/5'/ polishing the active material (30) so that the layer of dielectric material (40) is flush with a planar abrasion surface on a side opposed to the base structure (BS), the cavity filled with the active material forming an active portion (3); and
/6'/ forming the second electrode (2) on the active portion (3) on the side opposed to the base structure (BS),
wherein the active material (30) is varied in composition during step /2/ or /4'/, so that a relative dielectric permittivity is non-uniform along a direction (D) perpendicular to the planar surface (S) of the base structure (BS), or the dielectric material (40) is varied in composition during step /4/ or /2'/, so that a relative dielectric permittivity of said dielectric material is non-uniform along said direction perpendicular to the planar surface of the base structure.

## Patentansprüche

1. Schaltvorrichtung (10) aufweisend:
- mindestens zwei Elektroden (1, 2), welche entfernt voneinander angeordnet sind;
- einen aktiven Bereich (3), der sich zwischen den beiden Elektroden (1, 2) und im elektrischen Kontakt mit der Elektrode befindet, wobei der aktive Bereich so gewählt ist, dass der aktive Bereich in der Lage ist, von einem elektrisch isolierendem Zustand in einen elektrisch leitenden Zustand umzuschalten, wenn eine Spannung, die höher als ein Schwellwert ist, zwischen beiden Elektroden angelegt wird, wobei der elektrische Widerstand des aktiven Bereichs, der zwischen den beiden Elektroden besteht, für den leitenden Zustand im Vergleich zum isolierenden Zustand geringer ist; und
- einen passiven Bereich (4), welcher elektrisch isolierend ist und neben dem aktiven Bereich angeordnet ist,
wobei eine Materialzusammensetzung von mindestens einem aus dem aktiven Bereich (3) und dem passiven Bereich (4) zwischen zwei Punkten von mindestens einem Pfad (PATH1, PATH2) von einer der Elektroden (1) zu der anderen Elektrode (2) variiert, so dass eine relative dielektrische Permittivität entlang des Pfades ungleichmäßig ist, wodurch eine Konzentration eines elektrischen Feldes an mindestens einer Konzentrationsstelle innerhalb des aktiven Bereichs (3) erzeugt wird, wenn er sich im isolierenden Zustand befindet und eine Spannung ungleich 0 zwischen den beiden Elektroden (1, 2) angelegt wird, wobei das elektrische Feld somit an der Konzentrationsstelle höher ist als an einer anderen Stelle ebenfalls in dem aktiven Bereich,
**dadurch gekennzeichnet, dass**
eine Variation der relativen dielektrischen Permittivität zwischen zwei Punkten auf dem Pfad (PATH1, PATH2) höher als 6 ist.

2. Schaltvorrichtung (10) nach Anspruch 1,
wobei die Variation der relativen dielektrischen Permittivität zwischen zwei Punkten auf dem Pfad (PATH1, PATH2) höher als 10, bevorzugt höher als 20 ist.

3. Schaltvorrichtung (10) nach Anspruch 1 oder 2,
wobei für beide Elektroden (1, 2) eine jeweilige Kontaktschnittstelle (I₁, I₂) zwischen dem aktiven Bereich (3) und einer der Elektroden senkrecht zu einer gradlinigen Richtung (D) ist, welche sich von einer der Elektroden zu der anderen Elektrode erstreckt und der aktive Bereich (3) Seitenflächen (SF) aufweist, welche parallel zu der gradlinigen Richtung sind.

4. Schaltvorrichtung (10) nach Anspruch 3,
wobei der passive Bereich (4) zwischen zwei Ebenen (P₁, P₂) angeordnet ist, welche die Kontaktschnittstellen (I₁, I₂) enthalten und senkrecht zu der gradlinigen Richtung (D) sind, und der passive Bereich (4) den aktiven Bereich (3) zumindest teilweise seitlich umgibt.

5. Schaltvorrichtung (10) nach Anspruch 3 oder 4,
wobei die Materialzusammensetzung des aktiven Bereichs (3) zwischen beiden Elektroden (1, 2) variiert, so dass die relative dielektrische Permittivität innerhalb des aktiven Bereichs ungleichmäßig ist und die jeweiligen Querschnitte des aktiven Bereichs (3) und der Elektroden (1, 2) identisch sind, wobei die Querschnitte senkrecht zur gradlinigen Richtung (D) sind.

6. Schaltvorrichtung (10) nach einem der Ansprüche 3 bis 5,
wobei sich jede Elektrode (1, 2) senkrecht zur gradlinigen Richtung (D) über mindestens eine Seitenfläche (SF) des aktiven Bereichs (3) hinausstreckt und die Materialzusammensetzung des passiven Bereichs (4) zwischen den jeweiligen Vorsprüngen (E₁, E₂) der Elektroden (1, 2) variiert, die sich über die Seitenfläche (SF) des aktiven Bereichs hinaus erstrecken, so dass die relative dielektrische Permittivität innerhalb des passiven Bereichs zwischen den Elektrodenvorsprüngen ungleichmäßig ist.

7. Schaltvorrichtung (10) nach Anspruch 6,
wobei der passive Bereich (4) ein Stapel von mindestens zwei elektrisch isolierenden Schichten (4a, 4b) ist und der aktive Bereich (3) durch den Stapel hindurch angeordnet ist.

8. Schaltvorrichtung (10) nach Anspruch 7,
wobei eine erste (4a) der Schichten einen Wert ε_{LK} für die relative dielektrische Permittivität und eine Dicke t_{LK} hat und eine zweite (4b) der Schichten einen Wert ε_{HK} für die relative dielektrische Permittivität und eine Dicke t_{HK} hat und die folgenden Ungleichungen erfüllt sind: ε_{LK} < ε_{HK} und t_{LK} < t_{HK}, wobei die Dicken parallel zu der gradlinigen Richtung (D) gemessen werden.

9. Schaltvorrichtung (10) nach einem der Ansprüche 3 bis 8, des Weiteren aufweisend
einen Metallbereich (5), der neben dem aktiven Bereich (3) angeordnet ist, wobei der Metallbereich eine Dicke aufweist, die geringer ist als ein zwischen beiden Elektroden (1, 2) bestehender Trennabstand, wobei die Dicke des Metallbereichs und der Trennabstand parallel zur gradlinigen Richtung (D) gemessen werden.

10. Schaltvorrichtung (10) nach Anspruch 9,
wobei der Metallbereich (5) den aktiven Bereich (3) seitlich umgibt.

11. Schaltvorrichtung 810) nach Anspruch 9 oder 10,
wobei der Metallbereich (5) von jeder der Elektroden (1, 2) elektrisch isoliert ist, vorzugsweise ist der Metallbereich ein schwebender Metallbereich.

12. Schaltvorrichtung (10) nach Anspruch 7 und nach einem der Ansprüche 8 bis 11,
wobei der Metallbereich (5) zwischen den entsprechenden Bereichen der beiden elektrisch isolierten Schichten (4a, 4b) des passiven Bereichs (4) angeordnet ist.

13. Auswahlarray aufweisend:
- eine Schicht von ersten Elektroden (1), wobei alle ersten Elektroden durch jeweilige erste Leiterbahnen gebildet werden, die voneinander beabstandet und parallel zu einer ersten Richtung (D₁) sind;
- eine Schicht von zweiten Elektroden (2), wobei alle zweiten Elektroden durch jeweilige zweite Leiterbahnen gebildet sind, die voneinander beabstandet und parallel zu einer zweiten Richtung (D₂) sind, wobei die Schichten der ersten und zweiten Elektroden beide parallel zu einer Basisebene (S) sind und die ersten und zweiten Richtungen einander in einer Projektion auf die Basisebene kreuzen;
- aktive Bereiche (3), welche zwischen der Schicht der ersten Elektroden (1) und der Schicht der zweiten Elektroden (2) angeordnet sind, so dass jeder aktive Bereich eine der ersten Elektroden und eine der zweiten Elektroden mit jeweiligen elektrischen Kontaktschnittstellen (I₁, I₂) überbrückt; und
- passives Material (4), das sich zwischen benachbarten der aktiven Bereiche (3) befindet,
- so dass jeder aktive Bereich (3) eine Schaltvorrichtung (10) nach einem der vorangehenden Ansprüche ausbildet, mit entsprechenden Bereichen einer der ersten Elektroden (1) und einer der zweiten Elektroden (2) und mindestens einem Bereich des passiven Materials (4) der an den aktiven Bereich angrenzt.

14. Auswahlarray nach Anspruch 13,
geeignet zum Ausbilden eines Auswahlarrays für einen Direktzugriffsspeicher.

15. Verfahren zum Herstellen von mindestens einer Schaltvorrichtung (10) aufweisend einen der folgenden ersten und zweiten Schrittfolgen:
wobei die erste Schrittfolge aufweist:
/1/ Erhalten einer Basisstruktur (BS), die eine ebene Oberfläche (S) hat, und mindestens eine erste Elektrode (1) aufweist, die mit der ebenen Oberfläche bündig ist;
/2/ Ausbilden einer Schicht eines aktiven Materials (30) auf der ebenen Oberfläche (S) der Basisstruktur (BS), wobei das aktive Material so ausgebildet ist, dass es in der Lage ist, von einem elektrisch isolierenden Zustand in einen elektrisch leitenden Zustand umzuschalten, wenn eine Spannung, die höher als ein Schwellwert ist, zwischen zwei gegenüberliegenden Flächen der Schicht aus aktivem Material angelegt wird;
/3/ selektives Entfernen der Schicht des aktiven Materials (30) außerhalb des Bereichs, der sich über den ersten Elektroden (1) befindet, so dass ein Teil des aktiven Materials, der als aktiver Bereich bezeichnet wird, auf der ersten Elektrode verbleibt;
/4/ Deponieren eines dielektrischen Materials (40) auf der Basisstruktur (BS), so dass der aktive Bereich (3) in das dielektrische Material eingebettet wird;
/5/ Polieren des dielektrischen Materials (40), so dass der aktive Bereich (3) mit einer ebenen Abriebsfläche des dielektrischen Materials auf einer der Basisstrukturen (BS) gegenüberliegenden Seite bündig ist; und
/6/ Bilden einer zweiten Elektrode (2) auf dem aktiven Bereich (3) auf der der Basisstruktur (BS) gegenüberliegenden Seite,
und die zweite Schrittfolge aufweist:
/1'/ Erhalten einer Basisstruktur (BS), die eine ebene Oberfläche (S) hat, und mindestens eine erste Elektrode (1) aufweist, die mit der ebenen Oberfläche bündig ist;
/2'/ Deponieren einer Schicht eines dielektrischen Materials (40) auf der ebenen Oberfläche (S) der Basisstruktur (BS);
/3'/ selektives Entfernen des dielektrischen Materials (30) innerhalb eines Bereichs, der in einem Querschnitt der ersten Elektrode (1) parallel zu der ebenen Oberfläche (S) der Basisstruktur (BS) beinhaltet ist um einen Hohlraum auszubilden der sich bis zu der ersten Elektrode erstreckt;
/4'/ Füllen des Hohlraumes mit einem aktiven Material (30) ausgewählt um geeignet zu sein, von einem elektrisch isolierenden Zustand in einen elektrisch leitenden Zustand umzuschalten, wenn eine Spannung, die höher als ein Schwellwert ist, zwischen zwei gegenüberliegenden Flächen der Schicht aus aktivem Material angelegt wird;
/5'/ Polieren des aktiven Materials (30), so dass die Schicht des dielektrischen Materials (40) mit einer ebenen Abriebsfläche auf einer der Basisstrukturen (BS) gegenüberliegenden Seite bündig ist, wobei der Hohlraum der mit dem aktiven Material gefüllt ist, einen aktiven Bereich (3) bildet; und
/6'/ Bilden einer zweiten Elektrode (2) auf dem aktiven Bereich (3) auf der der Basisstruktur (BS) gegenüberliegenden Seite,
wobei das aktive Material (30) während der Schritte (2) oder (4') in seiner Zusammensetzung variiert wird, so dass eine relative dielektrische Permittivität in Länge einer Richtung (D) senkrecht zur ebenen Fläche (S) der Basisstruktur (BS) ungleichmäßig ist oder das elektrische Material (40) während des Schrittes (4) oder (2') in seiner Zusammensetzung variiert wird, so dass eine relative dielektrische Permittivität des dielektrischen Materials entlang der Richtung senkrecht zur ebenen Fläche der Basisstruktur ungleichmäßig ist.

## Revendications

1. Dispositif de commutation (10) comprenant :
- au moins deux électrodes (1, 2) qui sont agencées éloignées l'une de l'autre ;
- une portion active (3) qui est intermédiaire entre les deux électrodes (1, 2) et en contact électrique avec chaque électrode, la portion active étant sélectionnée de sorte que ladite portion active soit capable de commuter d'un état électriquement isolant à un état électriquement conducteur lorsqu'une tension qui est supérieure à une valeur de seuil est appliquée entre les deux électrodes, dans lequel une résistance électrique de la portion active existant entre les deux électrodes est inférieure pour l'état conducteur en comparaison avec l'état isolant ; et
- une portion passive (4) qui est électriquement isolante et agencée adjacente à la portion active,
dans lequel une composition de matériau d'au moins l'une parmi la portion active (3) et la portion passive (4) varie entre deux points d'au moins un chemin (PATH1 ; PATH2) de l'une des électrodes (1) à l'autre électrode (2), de sorte qu'une permittivité diélectrique relative soit non-uniforme le long dudit chemin, créant ainsi une concentration de champ électrique à au moins un emplacement de concentration à l'intérieur de la portion active (3) lorsqu'elle est dans l'état isolant et qu'une tension non-nulle est appliquée entre les deux électrodes (1, 2), le champ électrique étant ainsi supérieur à l'endroit de concentration par rapport à un autre endroit également à l'intérieur de ladite portion active,
**caractérisé en ce qu'**une variation de la permittivité diélectrique relative entre deux points du chemin (PATH1 ; PATH2) est supérieure à 6.

2. Dispositif de commutation (10) selon la revendication 1, dans lequel la variation de la permittivité diélectrique relative entre deux points du chemin (PATH1 ; PATH2) est supérieure à 10, de manière davantage préférée supérieure à 20.

3. Dispositif de commutation (10) selon la revendication 1 ou 2, dans lequel pour les deux électrodes (1, 2), une interface de contact (I₁, I₂) respective entre la portion active (3) et l'une des électrodes est perpendiculaire à une direction rectiligne (D) qui s'étend de l'une des électrodes à l'autre électrode, et la portion active (3) a des faces latérales (SF) qui sont parallèles à ladite direction rectiligne.

4. Dispositif de commutation (10) selon la revendication 3, dans lequel la portion passive (4) est située entre deux plans (P_{1,} P₂) qui contiennent les interfaces de contact (I₁, I₂) et sont perpendiculaires à la direction rectiligne (D), et la portion passive (4) entoure au moins partiellement la portion active (3) latéralement.

5. Dispositif de commutation (10) selon la revendication 3 ou 4, dans lequel la composition de matériau de la portion active (3) varie entre les deux électrodes (1, 2) de sorte que la permittivité diélectrique relative soit non uniforme à l'intérieur de ladite portion active, et des sections transversales respectives de la portion active (3) et des électrodes (1, 2) sont identiques, lesdites sections transversales étant perpendiculaires à la direction rectiligne (D).

6. Dispositif de commutation (10) selon l'une quelconque des revendications 3 à 5, dans lequel chaque électrode (1, 2) s'étend perpendiculairement à la direction rectiligne (D) au-delà d'au moins une face latérale (SF) de la portion active (3), et la composition de matériau de la portion passive (4) varie entre des protubérances (E₁, E₂) respectives des électrodes (1, 2) qui s'étendent latéralement au-delà de la face latérale (SF) de la portion active (3), de sorte que la permittivité diélectrique relative soit non-uniforme à l'intérieur de ladite portion passif entre les protubérances d'électrode.

7. Dispositif de commutation (10) selon la revendication 6, dans lequel la portion passive (4) est un empilement d'au moins deux couches électriquement isolantes (4a, 4b) et la portion active (3) est agencée à travers l'empilement.

8. Dispositif de commutation (10) selon la revendication 7, dans lequel une première (4a) des couches a une valeur ε_{LK} pour la permittivité diélectrique relative et une épaisseur t_{LK}, et une seconde (4b) des couches a une valeur ε_{HK} pour la permittivité diélectrique relative et une épaisseur t_{HK}, et les inégalités suivantes sont satisfaites : ε_{LK} < ε_{HK} et t_{LK} < t_{HK}, les épaisseurs étant mesurées parallèlement à la direction rectiligne (D).

9. Dispositif de commutation (10) selon l'une quelconque des revendications 3 à 8, comprenant en outre une portion en métal (5) qui est agencée adjacente à la portion active (3), ladite portion en métal ayant une épaisseur qui est inférieure à une distance de séparation existant entre les deux électrodes (1, 2), ladite épaisseur de la portion en métal et ladite distance de séparation étant mesurées parallèlement à la direction rectiligne (D).

10. Dispositif de commutation (10) selon la revendication 9, dans lequel la portion en métal (5) entoure latéralement la portion active (3).

11. Dispositif de commutation (10) selon la revendication 9 ou 10, dans lequel la portion en métal (5) est isolée électriquement de chacune des électrodes (1, 2), de préférence la portion en métal est une portion en métal flottante.

12. Dispositif de commutation (10) selon la revendication 7 et l'une quelconque des revendications 8 à 11, dans lequel la portion en métal (5) est située entre des portions respectives des deux couches électriquement isolantes (4a, 4b) de la portion passive (4).

13. Matrice de sélection, comprenant :
- une couche de premières électrodes (1), toutes les premières électrodes étant formées par des premières pistes conductrices respectifs qui sont espacées les unes des autres et parallèles à une première direction (D₁) ;
- une couche de secondes électrodes (2), toutes les secondes électrodes étant formées par des secondes pistes conductrices respectives qui sont espacées les unes des autres et parallèles à une seconde direction (D₂), les couches des premières et secondes électrodes étant toutes les deux parallèles à un plan de base (S) et les première et seconde directions se croisant l'une l'autre en projection sur le plan de base ;
- des portions actives (3) qui sont agencées entre la couche des premières électrodes (1) et la couche des secondes électrodes (2), de sorte que chaque portion active forme un pont entre l'une des premières électrodes et l'une des secondes électrodes avec des interfaces de contact électrique (I₁, I₂) respectives ; et
- un matériau passif (4) qui est situé entre des portions actives (3) qui sont voisines,
de sorte que chaque portion active (3) forme un dispositif de commutation (10) selon l'une quelconque des revendications précédentes, avec des portions respectifs de l'une des premières électrodes (1) et l'une des secondes électrodes (2), et au moins une portion du matériau passif (4) qui est adjacente à ladite portion active.

14. Matrice de sélection selon la revendication 13, appropriée pour former une matrice de sélection de mémoire vive (RAM).

15. Procédé de fabrication d'au moins un dispositif de commutation (10), comprenant l'une des première et seconde séquences suivantes d'étapes :
la première séquence d'étapes comprenant :
/1/ l'obtention d'une structure de base (BS) ayant une surface plane (S) et comprenant au moins une première électrode (1) qui est à fleur avec ladite surface plane ;
/2/ la formation d'une couche d'un matériau actif (30) sur la surface plane (S) de la structure de base (BS), le matériau actif étant sélectionné pour être capable de commuter d'un état électriquement isolant à un état électriquement conducteur lorsqu'une tension qui est supérieure à une valeur de seuil est appliquée entre deux surfaces opposées de ladite couche de matériau actif ;
/3/ le retrait sélectif de la couche du matériau actif (30) en dehors d'une zone qui est située au-dessus de la première électrode (1), de sorte qu'une portion du matériau actif, dénommée portion active (3), reste sur ladite première électrode ;
/4/ le dépôt d'un matériau diélectrique (40) sur la structure de base (BS), de sorte que la portion active (3) soit encastrée à l'intérieur du matériau diélectrique ;
/5/ le polissage du matériau diélectrique (40) de sorte que la portion active (3) soit à fleur avec une surface d'abrasion plane du matériau diélectrique sur un côté opposé à la structure de base (BS) ; et
/6/ la formation de la seconde électrode (2) sur la portion active (3) sur le côté opposé à la structure de base (BS),
et la seconde séquence d'étapes comprenant :
/1'/ l'obtention d'une structure de base (BS) ayant une surface plane (S) et comprenant au moins une première électrode (1) qui est à fleur avec ladite surface plane ;
/2'/ le dépôt d'une couche de matériau diélectrique (40) sur la surface plane (S) de la structure de base (BS) ;
/3'/ le retrait sélectif du matériau diélectrique (40) à l'intérieur d'une zone qui est comprise dans une section transversale de la première électrode (1) parallèlement à la surface plane (S) de la structure de base (BS), de façon à former une cavité qui s'étend jusqu'à la première électrode ;
/4'/ le remplissage de la cavité avec un matériau actif (30) sélectionné pour être capable de commuter d'un état électriquement isolant à un état électriquement conducteur lorsqu'une tension qui est supérieure à une valeur de seuil est appliquée entre deux surfaces opposées d'une portion dudit matériau actif ;
/5'/ le polissage du matériau actif (30) de sorte que la couche de matériau diélectrique (40) soit à fleur avec une surface d'abrasion plane sur un côté opposé à la structure de base (BS), la cavité remplie avec le matériau actif formant une portion active (3) ; et
/6'/ la formation de la seconde électrode (2) sur la portion active (3) sur le côté opposé à la structure de base (BS),
dans lequel une composition du matériau actif (30) est variée pendant les étapes /2/ ou /4'/, de sorte qu'une permittivité diélectrique relative soit non-uniforme le long d'une direction (D) perpendiculaire à la surface plane (S) de la structure de base (BS), ou la composition du matériau diélectrique (40) est variée pendant les étapes /4/ ou /2'/, de sorte qu'une permittivité diélectrique relative dudit matériau diélectrique soit non-uniforme le long de ladite direction perpendiculaire à la surface plane de la structure de base.
